Europäisches Patentamt

European Patent Office

Office européen des brevets

(11) Publication number: **0 551 646 A2**

# EUROPEAN PATENT APPLICATION

(21) Application number: **92121843.4**

(22) Date of filing: **23.12.92**

(51) Int. Cl.5: **H04L 1/00**

(30) Priority: **25.12.91 JP 342645/91**

(43) Date of publication of application:
**21.07.93 Bulletin 93/29**

(84) Designated Contracting States:
**CH DE ES FR GB IT LI NL SE**

(71) Applicant: **MATSUSHITA ELECTRIC INDUSTRIAL CO., LTD
1006, Oaza Kadoma, Kadoma-shi
Osaka 571(JP)**

(72) Inventor: **Furushima, Susumu
749-1, Saedocho, Midori-ku
Yokohama-shi(JP)**
Inventor: **Asano, Nobuo
15-404, Wakabadai-4-chome
Asahi-ku, Yokohama-shi(JP)**

(74) Representative: **Zimmermann, Heinz, Dipl.-Ing. et al
Patentanwälte Leinweber & Zimmermann
Rosenthal 7/II Aufg.
W-8000 München 2 (DE)**

(54) **Concatenated block and convolution encoder-decoder.**

(57) Disclosed is an error correction coding and decoding apparatus carrying out block decoding of coded information data on the basis of a generator polynomial. On the side of a transmitting station (18), each frame of information data is coded into a block coded data by a block encoder (19) by the use of a generator polynomial $G(x)$, and, after adding a tail bit to the coded data, the data is coded by a convolutional encoder (20) into a convolutional coded data and transmitted. On the side of a receiving station (22), the received convolutional coded data is decoded in a Viterbi decoder (24) in a reverse order by means of trace back, and the decoded data is then subjected to block decoding by a block decoder (25) by the use of a reciprocal polynomial $G'(x)$ that is the reciprocity of the generator polynomial $G(x)$ used in the block encoder, thereby minimizing an undesirable processing delay due to the trace back.

EP 0 551 646 A2

BACKGROUND OF THE INVENTION

Field of the Invention

This invention relates to an error correction coding and decoding apparatus used in the field of mobile radio communication, such as, a land mobile digital radio telephone system or a portable radio telephone system.

Description of the Prior Art

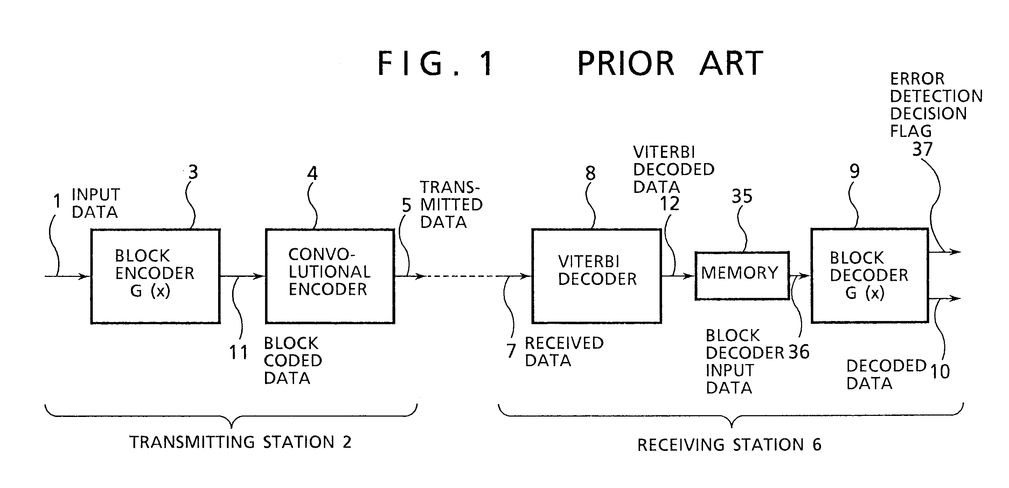

Fig. 1 shows the structure of a prior art error correction coding and decoding apparatus. Referring to Fig. 1, input data 1 to be encoded is supplied to a transmitting station 2. In the transmitting station 2, a block encoder 3 encodes the input data 1 by block coding which belongs to external character coding, and the block coded data 11 obtained by encoding the input data 1 by the block encoder 3 is supplied as an input to a convolutional encoder 4. The convolutional encoder 4 encodes the block coded data 11 by convolutional coding which belongs to internal character coding, and the resultant data 5 is outputted to be transmitted toward a receiving station 6.

In the receiving station 6, the transmitted data 5 is received as input data 7. A Viterbi decoder 8 decodes the received data 7 by Viterbi decoding which belongs to internal character decoding, and Viterbi decoded data 12 is supplied to a memory 35. The memory 35 stores the Viterbi decoded data 12 while reversing the order of the Viterbi decoded data 12. A block decoder 9 decodes block decoder input data 36 supplied from the memory 35 by block decoding which belongs to external character decoding, and decoded data 10 is outputted from the block decoder 9. An error detection decision flag 37 indicates whether the decoded data 10 is correct or not.

The operation of the prior art apparatus having the above structure will now be described. Referring to Fig. 1, the input data 1 is inputted to the transmitting station 2 in the form in which one frame consists of k information bits {I (0), I (1), ..., I (k - 1). The value of the input data is expressed by a sequence of 0 or 1. In the later description, the same applies to the value of data. The input data 1 is subjected to the error correction coding in both the block encoder 3 and the convolutional encoder 4 so that, even when a bit error may occur during transmission on the radio channel, the error can be corrected on the side of the receiving station 6. In the receiving station 6, one frame of the received data 7 is decoded, so that the decoded data 10 {Ir (0), Ir (1), ..., Ir (k - 1)} is finally outputted.

In the transmitting station 2 in which the input data 1 is encoded, check bits which may be m bits are acquired in the block encoder 3 for one frame consisting of k information bits {I (0), I (1), ..., I (k - 1)} according to a predetermined generator polynomial:

$$G(x) = (g_0) + (g_1)x + (g_2)x^2 + ... + (g_m)x^m$$

Where each of the coefficients $g_0$, $g_1$, $g_2$, ..., $g_m$ is 0 or 1. The same applies to all polynomials. The check bits are added to the information bits to obtain one word {B (0), B (1), ..., B (n - 1)} of n bits (n = k + m). Herein, I (0) = B (0), I (1) = B (1), ..., I (k - 1) = B (k - 1), and m bits from B (k) to B (n - 1) are check bits acquired from the generator polynomial G (x). To the tail of the word described above, tail bits consisting of i bits "0" are added to provide a new word {B (0), B (1), ..., B (n + i -1)} of (n + i) bits which is outputted as the block coded data 11. Herein, I (0) = B (0), I (1) = B (1), ..., I (k - 1) = B (k - 1), and the m bits from B (k) to B (n - 1) are the check bits acquired from the generator polynomial G (x). And yet, B (n) = B (n + 1) = ... = B (n + i -1) = 0.

The block coded data 11 is inputted to the convolutional encoder 4 to be sequentially encoded into the convolutional coded data. When the coding rate in the convolutional encoder 4 is p/q, the transmitted data 5 of p/q × (n + i) bits outputted from the convolutional encoder 4 is {T (0), T (1), ..., T (p/q × (n + i) - 1)}.

On the other hand, the receiving station 6 receives the received data 7 {Tr (0), Tr (1), ..., Tr (p/q × (n + i) - 1)} of p/q × (n + i) bits in which an error is added to the transmitted data 5 on the radio channel. The received data 7 is collectively decoded by the Viterbi decoder 8 by means of trace back. That is, the received data 7 is decoded in the reverse order of the received data 7 into Br (n + i - 1), ..., Br (1), Br (0).

In this case, the tail bits of the i bits added to the word in the transmitting station 2 are used for the purpose of terminating the pass during the Viterbi decoding, and these bits are eliminated at the end of the Viterbi decoding because they are now meaningless. As a result, the Viterbi decoded data 12 is outputted in the order of Br (n - 1), ..., Br (1), Br (0).

2

The Viterbi decoded data 12 is then inputted to the block decoder 9 in order to decide whether or not the data is correct. Before inputting the Viterbi decoded data 12 to the block decoder 9, it is necessary to reverse the order of the Viterbi decoded data 12 so as to restore the original proper order. For this purpose, the memory 35 is provided so as to temporarily store the data 12. The operation of the memory 35 will now be described. As soon as the data 7 is decoded by the Viterbi decoder 8 by means of trace back in the order from Br (n - 1), the data 12 is sequentially stored in the memory 35 until all the data 12 from Br (n - 1) to Br (0) is completely stored. Then, the stored data is read out from the memory 35 in the order of Br (0), Br (1), ..., Br (n - 1) to be inputted to the block decoder 9.

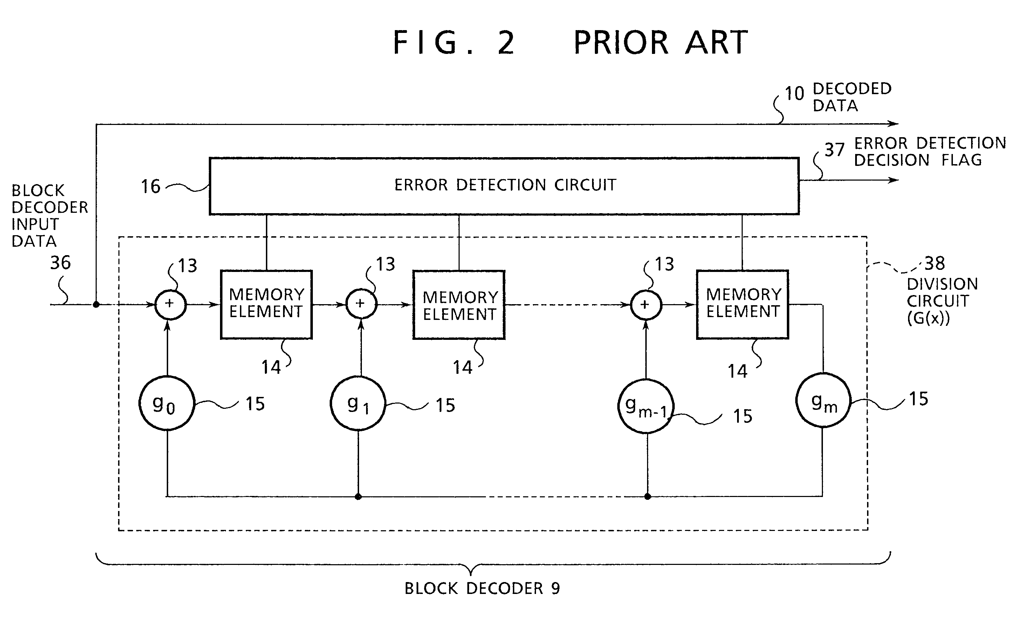

The block decoder 9 has a structure as shown in Fig. 2. Referring to Fig. 2, the block decoder 9 includes a division circuit 38 for providing the generator polynomial G (x) and is composed of exclusive-OR gates 13, memory elements 14 and coefficient elements 15 providing the coefficients in the generator polynomial:

$$G(x) = (g_0) + (g_1)x + (g_2)x^2 + ... + (g_m)x^m$$

used in the block encoder 3 shown in Fig. 1. When the value of any one of the coefficient elements 15 is 1, the connection line extending toward the associated exclusive-OR circuit 13 exists, while when the value of any one of the coefficient elements 15 is 0, the connection line extending toward the associated exclusive-OR circuit 13 does not exist.

The block decoder input data 36 inputted to the block decoder 9 is subjected to division in the division circuit 38. The block decoder input data 36 is inputted to the division circuit 38 and, at the same time, directly outputted as the decoded data 10. The block decoder input data 36 is inputted in the order of Br (0), Br (1), ..., Br (n - 1). As soon as Br (n - 1) is finally inputted, the division circuit 38 decides as to whether or not the decoded data 10 {lr (0), lr (1), ..., lr (k - 1)} corresponding to the one-frame input data 1 {I (0), I (1), ..., I (k - 1)} inputted to the transmitting station 2 is correct. When an error is detected, the result is indicated by the error detection decision flag 37 appearing from an error detection circuit 16.

Thus, in the prior art error correction coding and decoding apparatus, both the block coding and the convolutional coding are carried out in the coding mode, and both the Viterbi decoding and the block decoding are carried out in the decoding mode, so that error correction and error detection can be attained for a data input of one frame.

However, in the prior art error correction coding and decoding apparatus described above, the Viterbi decoded data 12 cannot be outputted unless the data of one frame is completely decoded in the reverse order by means of trace back in the Viterbi decoder 8. Therefore, the prior art apparatus has had the problem that the process of Viterbi decoding and the process of block decoding can only be serially carried out.

JP-A-1-291525 discloses a decoder in which a memory of a two way structure is used to make data input and data output in a different order. Although the cited application is advantageous in that an output buffer need not be provided, the disclosed decoder is also defective in that an undesirable delay of processing is inevitable as in the case of the prior art apparatus described above.

SUMMARY OF THE INVENTION

It is an object of the present invention to provide an error correction coding and decoding apparatus in which data can be sequentially outputted before the data of one frame is completely decoded by means of trace back, and the process of block decoding can be serially carried out while carrying out the process of Viterbi decoding, so that an undesirable delay of processing can be minimized.

According to the present invention which attains the above object, a reciprocal polynomial:

$$G'(x) = (g_m) + (g_{m-1})x + (g_{m-2})x^2 + ... + (g_0)x^m$$

which is the reciprocity of the generator polynomial:

$$G(x) = (g_0) + (g_1)x + (g_2)x^2 + ... + (g_m)x^m$$

is used in its block decoder.

Therefore, according to the present invention, in spite of the fact that data decoded in its Viterbi decoder in the reverse order by means of trace back is sequentially inputted to its block decoder, the reciprocal polynomial G'(x) used in the block decoder has a coefficient sequence reverse to that of the generator polynomial G(x), so that the process of block decoding can be immediately carried out while carrying out the process of Viterbi decoding, thereby minimizing an undesirable delay of processing during decoding.

## BRIEF DESCRIPTION OF THE DRAWINGS

Fig. 1 is a schematic block diagram showing the structure of a prior art error correction coding and decoding apparatus.

Fig. 2 shows in detail the structure of the block decoder in the prior art apparatus shown in Fig. 1.

Fig. 3 is a schematic block diagram showing the structure of an embodiment of the error correction coding and decoding apparatus according to the present invention.

Fig. 4 shows in detail the structure of the block decoder in the apparatus of the present invention shown in Fig. 3.

## DESCRIPTION OF THE PREFERRED EMBODIMENT

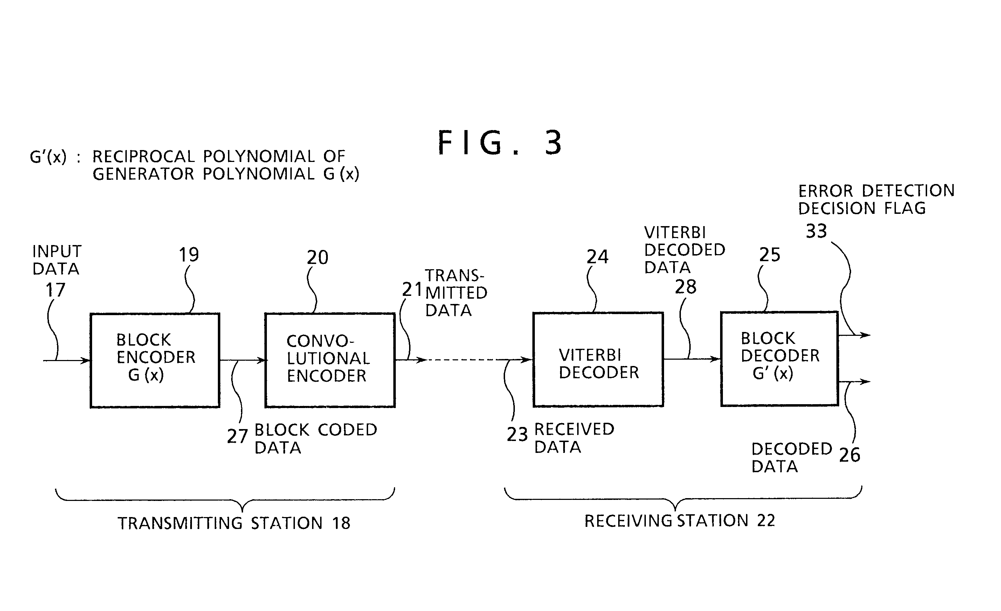

Fig. 3 shows schematically the structure of the error correction coding and decoding apparatus of the present invention. Referring to Fig. 3, input data 17, for example, voice data to be encoded is inputted to a transmitting station 18. A block encoder 19 encodes the input data 17 by block coding, and block coded data 27 appears from the block encoder 19. A convolutional encoder 20 encodes the block coded data 27 by convolutional coding, and the resultant data 21 to be transmitted appears from the convolutional encoder 20. The data 21 is transmitted toward a receiving station 22 by, for example, a radio channel.

The transmitted data 21 is received as received data 23 in the receiving station 22. The received data 23 is decoded by a Viterbi decoder 24, and the Viterbi decoded data 28 from the Viterbi decoder 24 is checked by a block decoder 25 whether an error exists or not.

The operation of the embodiment of the present invention will now be described. One frame of the data 17 inputted to the transmitting station 18 consists of k information bits $\{I(0), I(1), ..., I(k-1)\}$. The value of the input data 17 is expressed by a sequence of 0 or 1. The same applies to the value of data described later. Error correction coding is carried out in both the block encoder 19 and the convolutional encoder 20, so that, even when a bit error may occur during transmission on the radio channel, the error can be corrected on the side of the receiving station 22. In the receiving station 22, one frame of the received data 23 is decoded, and the decoded data 26 $\{Ir(0), Ir(1), ..., Ir(k-1)\}$ is finally outputted.

In the transmitting station 18 in which the input data 17 is encoded, the block encoder 19 acquires m check bits for one frame consisting of k information bits $\{I(0), I(1), ..., I(k-1)\}$ according to a predetermined generator polynomial

$$G(x) = (g_0) + (g_1)x + (g_2)x^2 + ... + (g_m)x^m$$

Herein, the value of each of the coefficients $g_0, g_1, g_2, ..., g_m$ is 0 or 1. The same applies to all polynomials.

The check bits are added to the information bits to obtain one word $\{B(0), B(1), ..., B(n-1)\}$ of n bits $(n = k + m)$. Herein, $I(0) = B(0), I(1) = B(1), ..., I(k-1) = B(k-1)$, and the check bits, that is, m bits from $B(k)$ to $B(n-1)$ are acquired from the generator polynomial $G(x)$. To the tail of the above word, tail bits consisting of i bits "0" are added to obtain a new word $\{B(0), B(1), ..., B(n+i-1)\}$ of $(n+i)$ bits which provides the block coded data 27. Herein $I(0) = B(0), I(1) = B(1), ..., I(k-1) = B(k-1)$, and $B(n) = B(n+1) = ... = B(n+i-1) = 0$.

Then, the block coded data 27 is inputted to the convolutional encoder 20 to be sequentially encoded by convolutional coding. When the coding rate is p/q, the data 21 $\{T(0), T(1), ..., T(p/q \times (n+i) - 1)\}$ of $(p/q \times (n+i))$ bits is outputted to be transmitted toward the receiving station 22.

The receiving station 22 receives the data 23 $\{Tr(0), Tr(1), ..., Tr(p/q \times (n+i) - 1)\}$ of $(p/q \times (n+i))$ bits in which a bit error is added to the data 21. The Viterbi decoded data 28 $\{Br(0), Br(1), ..., Br(n+i-1)\}$ to be outputted from the Viterbi decoder 24 is collectively decoded by means of trace back, so that the data is decoded in the reverse order of $Br(n+i-1), ..., Br(1), Br(0)$.

The tail bits of i bits added in the transmitting station 18 for the purpose of terminating the pass during the Viterbi decoding becomes meaningless at the end of the Viterbi decoding. Therefore, these bits are not supplied to the block decoder 25.

As a result, the Viterbi decoded data 28 is outputted from the Viterbi decoder 24 in the order of $Br(n-1), Br(n-2), ..., Br(0)$. Before all the Viterbi decoded data 28 is decoded by the trace back, the data 28 is sequentially inputted to the block decoder 25 in the order from $Br(n-1)$.

EP 0 551 646 A2

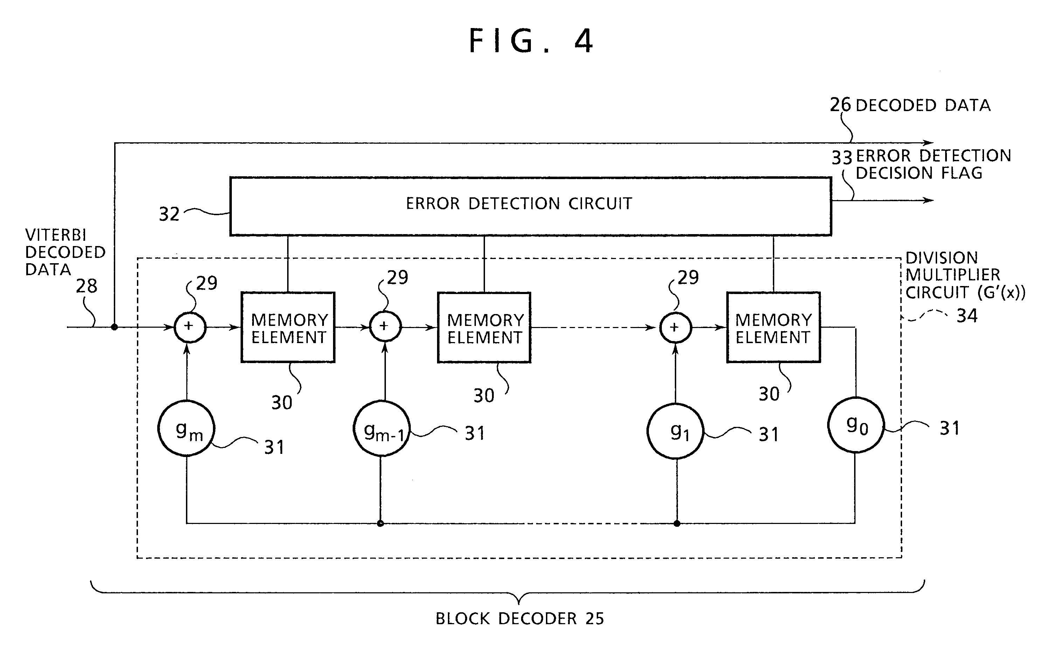

The block decoder 25 has a structure as shown in Fig. 4. Referring to Fig. 4, the block decoder 25 includes a division circuit 34 for providing the reciprocal polynomial G'(x) of the generator polynomial G(x). This circuit 34 is composed of exclusive-OR gates 29, memory elements 30 and coefficient elements 31 of the reciprocal polynomial:

$$G'(x) = (g_m) + (g_{m-1})x + (g_{m-2})x^2 + ... + (g_m)x^m$$

of the generator polynomial:

$$G(x) = (g_0) + (g_1)x + (g_2)x^2 + ... + (g_m)x^m$$

used in the block encoder 19 shown in Fig. 3. When the value of any one of the coefficient elements 31 is 1, the connection line extending toward the associated exclusive-OR gate 29 exists, while when the value of any one of the coefficient elements 31 is 0, the connection line extending toward the associated exclusive-OR gate 29 does not exist.

The Viterbi decoded data 28 is inputted to the division circuit 34, and, at the same time, directly outputted as the decoded data 26. The Viterbi decoded data 28 is inputted to the multiplier circuit 34 in the order of Br (n - 1), Br (n - 2), ..., Br (0). When Br (0) is finally inputted, the multiplier circuit 34 decides whether the decoded data 26 is correct or not, and the result is indicated by the error detection decision flag 33 appearing from the error detection circuit 32.

How error detection for the data decoded in the reverse order by the trace back can be attained by the use of the division circuit 34 providing the reciprocal polynomial G'(x) in lieu of the generator polynomial G-(x) will now be described.

The generator polynomial G(x) is expressed as

$$G(x) = g_0 + g_1x + g_2x^2 + ... + g_mx^m$$

and the reciprocal polynomial G'(x) is expressed as

$$G'(x) = g_m + g_{m-1}x + g_{m-2}x^2 + ... + g_0x^m$$

Suppose now a polynomial B (x) in which the block coded data {B (0), B (1), ..., B (n - 1)} is used to express the generator polynomial G (x) as follows:

$$B(x) = b_0 + b_1x + b_2x^2 + ... + b_{n-1}x^{n-1}$$

In the above polynomial, B (0), B (1), ..., B (n - 1) are expressed as B (0) = $b_0$, B (1) = $b_1$, ..., B (n - 1) = $b_{n-1}$ respectively. Because B (x) is divisible by G(x), the following relation holds.

$$\{B(x)\} \bmod \{G(x)\} = 0 \qquad ①$$

As far as the above relation ① holds, a polynomial A (x) given by

$$A(x) = a_0 + a_1x + a_2x^2 + ... + a_cx^c$$

is used to provide the following equation.

$$B(x) = G(x) \cdot A(x) \qquad ②$$

Suppose then the following polynomial B'(x)

$$B'(x) = b_{n-1} + b_{n-2}x + ... + b_0x^{n-1}$$

which has a coefficient sequence $b_{n-1}$, $b_{n-2}$, ..., $b_0$ reverse to that of the polynomial B (x). Then, the following relation holds:

$$\{B'(x)\} \bmod \{G'(x)\} = 0 \qquad ③$$

5

This means that, when the polynomial B'(x) is given by

$$B'(x) = G'(x) \cdot A'(x) \qquad ④,$$

error detection can be attained by the use of the reciprocal polynomial G'(x). The polynomial A'(x) is given by

$$A'(x) = a_c + a_{c-1}x + a_{c-2}x^2 + ... + a_0 x^c$$

Now, the individual polynomials are practically substituted in the equation ② proved to hold already so as to obtain the following equation:

$$
\begin{aligned}
b_0 &+ b_1 x + b_2 x^2 + ... + b_{m-1} x^{m-1} \\
&= (g_0 + g_1 x + g_2 x^2 + ... + g_m x^m)(a_0 + a_1 x + a_2 x^2 + ... + a_c x^c) \\
&= g_0 a_0 + g_1 a_0 x + g_2 a_0 x^2 + ... + g_{m-1} a_0 x^{m-1} + g_m a_0 x^m \\
&+ g_0 a_1 x + g_1 a_1 x^2 + ... + g_{m-2} a_1 x^{m-1} + g_{m-1} a_1 x^m + g_m a_1 x^{m+1} \\
&+ g_0 a_2 x^2 + ... + g_{m-3} a_2 x^{m-1} + g_{m-2} a_2 x^m + g_{m-1} a_2 x^{m+1} \\
&+ g_m a_1 x^{m+2} + ... + g_m a_0 x^{c+m} \qquad ⑤
\end{aligned}
$$

In the above equation, n - 1 = c + m. From the coefficients of the both side members of the equation ⑤, the values of the coefficients $b_0$, $b_1$, $b_2$, ..., $b_{n-1}$ are as follows:

$$b_0 = g_0 a_0$$

$$b_1 = g_1 a_0 + g_0 a_1$$

$$b_2 = g_2 a_0 + g_1 a_1 + g_0 a_2 \qquad ... \qquad ⑥$$

$$\bullet$$

$$\bullet$$

$$b_{n-1} = g_m a_c$$

Suppose further that the polynomial B'(x) is given by

$$B'(x) = G'(x) \cdot A'(x)$$

Then, the following equation is obtained:

$$
\begin{aligned}
b_{n-1} &+ b_{n-2} x + b_{n-3} x^2 + ... + b_0 x^{n-1} \\
&= (g_m + g_{m-1} x + g_{m-2} x^2 + ... + g_0 x^m)(a_c + a_{c-1} x + a_{c-2} x^2 + ... + a_c x^c) \\
&= g_m a_c + g_{m-1} a_c x + g_{m-2} a_c x^2 + ... + g_0 a_c x^m \\
&+ g_m a_{c-1} x + g_{m-1} a_{c-1} x^2 + ... + g_1 a_{c-1} x^m + g_0 a_{c-1} x^{m+1} \\
&+ g_m a_{c-2} x^2 + ... + g_2 a_{c-2} x^m + g_1 a_{c-2} x^{m+1} + g_0 a_{c-2} x^{m+2} \\
&+ g_0 a_0 x^m \qquad ⑦
\end{aligned}
$$

The coefficients of the both side members of the equation ⑦ teach that the equation ⑦ is equivalent to the following equations ⑧:

6

$$b_{n-1} = g_m a_c$$

$$\vdots$$

$$\cdots \quad ⑧$$

$$b_0 = g_0 a_0$$

When now the equations ⑥ and ⑧ are compared, the equation ⑧ is the same as the equation ⑥. Therefore the equation ④ holds. That is, even in the form of the data decoded in the reverse order by the trace back, error correction can be attained by the division circuit 34 adapted for providing the reciprocal polynomial G'(x) in lieu of the generator polynomial G(x).

It will be understood from the foregoing description of the embodiment of the present invention that, in spite of the fact that the received data 23 is decoded by the Viterbi decoder 24 in the reverse order by the trace back, the reciprocal polynomial that is the reciprocity of the generator polynomial used in the block encoder 19 is used in the block decoder 25 in the form in which the coefficient sequence is reversed, so that the process of block decoding can be immediately started. Therefore, the Viterbi decoded data 28 can be sequentially inputted to the block decoder 25 without the need for passing the data through the memory required in the prior art apparatus, so that the process of Viterbi decoding and the process of block decoding can be carried out in parallel. Thus, the present invention is advantageous in that the data decoding can be achieved with a minimized delay of processing, and the memory required hitherto for data storage can be eliminated.

**Claims**

1.  An error correction coding and decoding apparatus comprising:
    on a side of a transmitting station (18), a first encoder (19) for encoding each frame of information data into a block coded data by use of a generator polynomial, and a second encoder (20) for encoding the block coded data outputted from said first encoder (19) into a convolutional coded data and transmitting the convolutional coded data; and
    on a side of a receiving station (22), a first decoder (24) for decoding the received convolutional coded data in a reverse order by means of trace back and outputting convolutional decoded data in the reverse order, and a second decoder (25) subjecting the convolutional decoded data outputted from said first decoder (24) to block decoding by use of a reciprocal polynomial in which order of coefficients is reversed to that of said generator polynomial.

2.  An error correction coding and decoding apparatus according to Claim 1, wherein said information data is voice data.

3.  An error correction coding and decoding apparatus according to Claim 1, wherein said generator polynomial is given by

    $$G(x) = (g_0) + (g_1)x + (g_2)x^2 + \ldots + (g_m)x^m$$

    and said reciprocal polynomial is given by

    $$G'(x) = (g_m) + (g_{m-1})x + (g_{m-2})x^2 + \ldots + (g_0)x^m$$

    (Where each of the coefficients $g_0$, $g_1$, $g_2$, ..., $g_m$ is 0 or 1.)

4.  An error correction decoding apparatus comprising at least a first decoder (24) for subjecting information data, encoded into a block coded data by use of a generator polynomial and then encoded into a convolutional coded data on a side of a transmitting station, to Viterbi decoding by means of trace back and outputting convolutional decoded data in the same order as Viterbi decoding, and a second decoder (25) for subjecting the convolutional decoded data outputted from said first decoder to block decoding by use of a reciprocal polynomial in which order of coefficients is reversed to that of said generator polynomial.

5. An error correction decoding apparatus according to Claim 4, wherein said information data is voice data.

6. An error correction coding and decoding apparatus comprising:

first encoding means (19) for encoding each frame of information data into a block coded data by use of a generator polynomial;

second encoding means (20) for encoding the block coded data outputted from said first encoding means (19) into a convolutional coded data and outputting the convolutional coded data to a transmission channel;

first decoding means (24) for decoding the convolutional coded data received from the transmission channel in a reverse order by means of trace back and outputting convolutional decoded data in the reverse order; and

second decoding means (25) for subjecting the convolutional decoded data outputted from said first decoding means (24) to block decoding by use of a reciprocal polynomial in which order of coefficients is reversed to that of said generator polynomial.

FIG. 1   PRIOR ART

# FIG. 2 PRIOR ART

10 DECODED DATA

37 ERROR DETECTION DECISION FLAG

16 ERROR DETECTION CIRCUIT

BLOCK DECODER INPUT DATA

36

13 + MEMORY ELEMENT

13 + MEMORY ELEMENT

13 + MEMORY ELEMENT

38 DIVISION CIRCUIT (G(x))

14

14

14

$g_0$  15

$g_1$  15

$g_{m-1}$  15

$g_m$  15

BLOCK DECODER 9

EP 0 551 646 A2

EP 0 551 646 A2

# FIG. 3

G'(x) : RECIPROCAL POLYNOMIAL OF
GENERATOR POLYNOMIAL G (x)

INPUT DATA 17 → BLOCK ENCODER G (x) **19** → 27 BLOCK CODED DATA → CONVO-LUTIONAL ENCODER **20** → 21 TRANS-MITTED DATA ----→ VITERBI DECODER **24** → 23 RECEIVED DATA → VITERBI DECODED DATA 28 → BLOCK DECODER G' (x) **25** → ERROR DETECTION DECISION FLAG 33

DECODED DATA 26

TRANSMITTING STATION 18

RECEIVING STATION 22

# FIG. 4

26 DECODED DATA

33 ERROR DETECTION DECISION FLAG

ERROR DETECTION CIRCUIT

32

VITERBI DECODED DATA

28

29

MEMORY ELEMENT

30

$g_m$

31

29

MEMORY ELEMENT

30

$g_{m-1}$   31

29

MEMORY ELEMENT

30

$g_1$   31

DIVISION MULTIPLIER CIRCUIT (G'(x))

34

$g_0$   31

BLOCK DECODER 25

EP 0 551 646 A2